# EUROPEAN PATENT APPLICATION

(11) **EP 1 482 636 A1**
(43) Date of publication of application: **01.12.2004**
(21) Application number: 04253058.4
(22) Date of filing: 25.05.2004
(51) Int. Cl.: H03F 1/02, H04B 1/40, H04Q 7/32

(54) **Front end module**

(30) Priority: 28.05.2003 GB 0312223
(71) Applicant: Ubinetics Limited, Melbourn, Hertfordshire SG8 6DP (GB)
(72) Inventor: Reynolds, David, Waterbeach Cambridgeshire CB5 9QL (GB)
(74) Representative: Pratt, David Martin

(57) **Abstract**

A front end module (21) for a dual mode radio receiver has first and second amplifiers (25 and 28) in respective first and second transmission paths (23 and 26) for the two modes. The front end module (21) is provided with a battery (29) for powering the amplifiers (25 and 28), and with a step up/down DC-DC converter (30) for controlling the voltage supplied by the battery to the two amplifiers.

## Description

This invention relates to a front end module for a dual mode radio, and in particular to a front end module for a GSM/UMTS mobile phone handset.

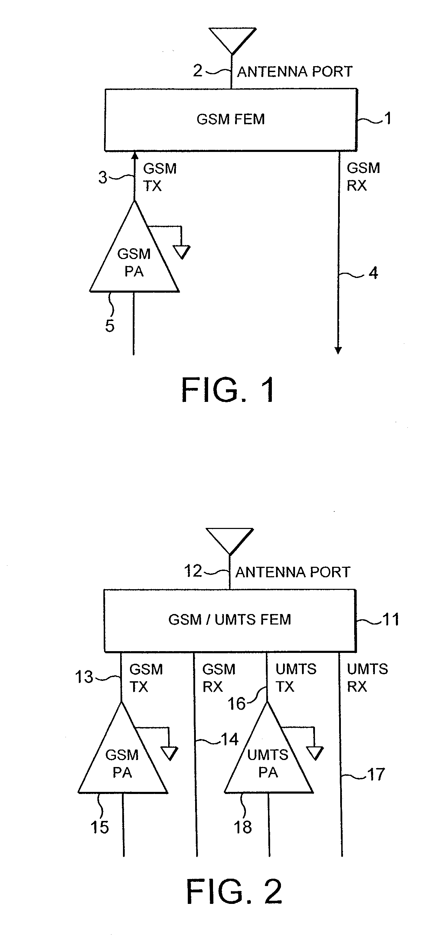

The front end module of a mobile phone handset is that portion of the handset which is positioned between the antenna of the handset and its transceiver, and acts to switch between transmit and receive operations. Thus, as shown in Figure 1, a front end module 1 of a GSM phone handset (not shown) switches telecommunications signals between an antenna 2 and GSM transmit and receive paths 3 and 4. The GSM transmit path 3 includes a GSM power amplifier 5. The amplifier 5 is designed specifically for GSM transmission, and is specified down to a battery supply of 3 volts for maintaining the required GSM performance over battery and temperature extremes.

As mobile phone technology improves, GSM networks are being replaced by G3 (UMTS) networks. New mobile phone handsets do, therefore, need to operate on both GSM and UMTS networks, and this leads to the need for multi-mode, multi-band handsets with ever-increasing complexity.

For a GSM/UMTS mobile phone handset, the current trend is to use an enhanced GSM front end module in a dual mode application, with both GSM and UMTS transmit and receive paths connected to the module. Thus, as shown in Figure 2, a GSM/UMTS front end module 11 of a GSM/UMTS mobile phone handset (not shown) switches telecommunications signals between an antenna 12 and either GSM transmit and receive paths 13 and 14 or UMTS transmit and receive paths 16 and 17. A GSM power amplifier 15 is provided in the GSM transmit path 13, and a UMTS power amplifier 18 is provided in the UMTS transmit path 16.

As mentioned above, it is usual for the GSM power amplifier 15 to be a standard power amplifier. As the amplifier is designed for maximum performance with a signal mode front end module such as the module 1, the extra attenuation which results from the use of a dual mode front end module such as the module 11, means that it is impossible to maintain the GSM transmit power output over battery and temperature extremes.

The aim of the invention is to provide a dual mode front end module that can be used with a standard GSM power amplifier whilst maintaining GSM transmit power output over battery and temperature extremes.

The present invention provides a front end module for a dual mode radio receiver having first and second amplifiers in respective first and second transmission paths for the two modes, the front end module being provided with a battery for powering the amplifiers, and with a step up/down DC-DC converter for controlling the voltage supplied to the two amplifiers.

In a preferred embodiment, the first amplifier is a GSM power amplifier, and the second amplifier is a UMTS power amplifier.

Preferably, the converter is arranged to output a stepped-up voltage to the first amplifier and to output a stepped-down voltage to the second amplifier.

Advantageously, the converter is arranged to provide a voltage in the range of from 3.6 volts to 4.2 volts to the first amplifier.

In a preferred embodiment, the converter is arranged to provide a stepped-down voltage when the output power of the second amplifier is less than the maximum output power. Conveniently, the converter is arranged to provide a stepped-down voltage of 3.6 volts to the second amplifier when the output power is reduced to 10 dBm.

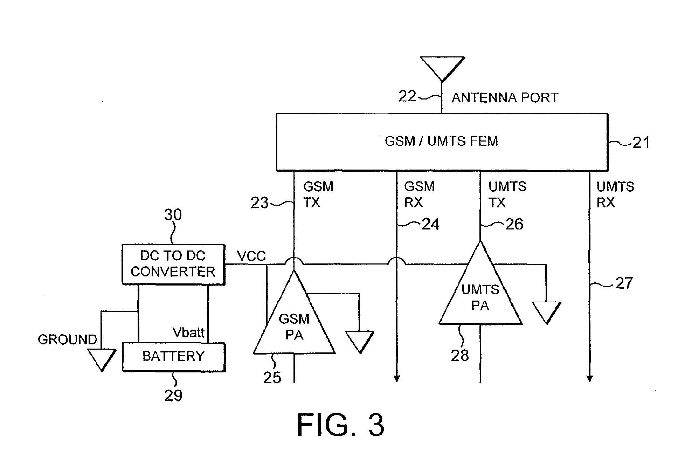

The invention will now be described in greater detail, by way of example, with reference to Figure 3 of the drawings which show schematically a front end module constructed in accordance with the invention.

Referring to Figure 3, a front end module 21 of a GSM/UMTS mobile phone handset (not shown) switches telecommunications signals between an antenna 22 and either GSM transmit and receive paths 23 and 24, or UMTS transmit and receive paths 26 and 27. A standard GSM power amplifier 25 is provided in the GSM transmit path 23, and a UMTS power amplifier 28 is provided in the UMTS transmit path 26. The two power amplifiers 25 and 28 are powered by a lithium-ion battery 29 via a DC to DC converter 30. The converter 30 is a step up/down converter which is arranged to provide a steady output voltage matched to either the required input voltage of the GSM power amplifier 25 or the UMTS power amplifier 28.

Thus, when the front end module 21 is operating in the GSM mode, the converter 30 provides a stepped-up voltage (in the range of from 3.6 volts to 4.2 volts) to the GSM power amplifier 25, effectively taking advantage of the improved performance of that amplifier at these higher voltage levels. This increased power performance is better than that required to overcome the attenuation loss introduced by the dual mode front end module 21 in the GSM transmit path 23.

As shown, the converter 30 is also used to supply the UMTS power amplifier 28, and this results in improved gain/efficiency of that amplifier as well as improved ACP (automatic power control) stability. An additional benefit of using the converter 30 to power the UMTS power amplifier 28 is that the battery can then use a much lower voltage, resulting in longer standby and data download/talk time. Thus, if a UMTS power amplifier is operated in class A or class AB mode, it draws current (quiescent current) all the time it is on. This current level is set to get the linearity (compression point) sufficiently high enough not to cause ACP problems at maximum transmit power. The quiescent current can be controlled by varying the voltage supply of the amplifier, enabling the use of a lower current; and this will, in turn, reduce the linearity/compression point of the power amplifier. Thus, using this principle, it is possible to conserve current (and hence increase efficiency) by reducing the voltage supply to the UMTS power amplifier 28 for lower transmit levels. For example, when the UMTS power amplifier 28 is at full transmit power (21/24 dBm at the antenna 22) the supply voltage to the amplifier may be 3.8 volts. When the output power is reduced to 10 dBm, however, the voltage supply can be reduced to 3.6 volts to conserve the current draw and to improve the efficiency of the handset.

## Claims

1. A front end module for a dual mode radio receiver having first and second amplifiers in respective first and second transmission paths for the two modes, the front end module being provided with a battery for powering the amplifiers, and with a step up/down DC-DC converter for controlling the voltage supplied to the two amplifiers.

2. A front end module as claimed in claim 1, wherein the first amplifier is a GSM power amplifier, and the second amplifier is a UMTS power amplifier.

3. A front end module as claimed in claim 1 or claim 2, wherein the converter is arranged to output a stepped-up voltage to the first amplifier and to output a stepped-down voltage to the second amplifier.

4. A front end module as claimed in claim 3, wherein the converter is arranged to provide a voltage in the range of from 3.6 volts to 4.2 volts to the first amplifier.

5. A front end module as claimed in claim 3 or claim 4, wherein the converter is arranged to provide a stepped-down voltage when the output power of the second amplifier is less than the maximum output power.

6. A front end module as claimed in claim 5, wherein the converter is arranged to provide a stepped-down voltage of 3.6 volts to the second amplifier when the output power is reduced to 10 dBm.
